# EUROPÄISCHE PATENTSCHRIFT

(11) **EP 2 256 823 B1**
(45) Veröffentlichungstag und Bekanntmachung des Hinweises auf die Patenterteilung: **13.12.2017**
(21) Anmeldenummer: 10005275.2
(22) Anmeldetag: 20.05.2010
(51) Int. Cl.: H01L 31/02

(54) **Solarpaneel und Verwendung des Solarpaneels**
Solar panel and use of the solar panel
Panneau solaire et utilisation du panneau solaire

(30) Priorität: 25.05.2009 DE 102009022569
(43) Veröffentlichungstag der Anmeldung: 01.12.2010
(73) Patentinhaber: Yamaichi Electronics Deutschland GmbH, 85609 Aschheim-Dornach (DE)
(72) Erfinder: Michel, Dirk, 85716 Unterschleißheim (DE); Quiter, Michael, 57482 Wenden (DE)
(74) Vertreter: Müller-Boré & Partner Patentanwälte PartG mbB

(56) Entgegenhaltungen:
- WO-A1-2009/035995
- US-A- 5 513 075
- US-A1- 2005 121 067

## Beschreibung

Die Erfindung betrifft ein Solarpaneel und eine Verwendung des Solarpaneels.

Herkömmliche Solarpaneele zur Erzeugung elektrischer Energie aus Sonnenlicht umfassen eine oder mehrere Solarzellengruppen, in denen je nach gewünschter von der Solarzellengruppe zur Verfügung zu stellenden Spannung und/oder Stromstärke einzelne Solarzellen parallel und/oder in Reihe geschaltet sind. Die elektrischen Anschlüsse der Solarzellengruppen des Solarmoduls werden nach außen geführt und an den Anschlußpolen einer Anschlußdose einem elektrischen Verbraucher unmittelbar oder mittelbar über Akkumulatoren oder über einen Wechselrichter zur Verfügung gestellt.

Abhängig von der auf das Solarpaneel wirkenden Bestrahlungsintensität durch Sonnenlicht, kann das Solarpaneel eine variable elektrische Leistung zur Verfügung stellen. Daher kann an den Anschlußpolen der Anschlußdose, je nach Bestrahlungsintensität auf das Solarpaneel, eine unterschiedliche Spannung anliegen bzw. über die Anschlußpole eine variable Stromstärke fließen. Folglich kann der an dem Solarpaneel angeschlossene Verbraucher sowohl mit unzureichender Spannung bzw. unzureichendem Strom als auch mit Überspannung versorgt werden.

Die Druckschrift US 5,513,075 offenbart ein Verbindermodul, welches eine elektrische Verbindung zwischen einer Leiterplatte oder einem Solarmodul und Anschlussleitungen herstellen kann.

Die Druckschrift US 2005/0121067 A1 offenbart eine Anordnung von Solarzellen, welche einen Inverter speisen, welcher einen Wechselstrom bereitstellt.

Es ist Aufgabe der Erfindung, ein Solarpaneel bereitzustellen, welches eine zuverlässige Stromversorgung der angeschlossenen Verbraucher ermöglicht.

Die Aufgabe wird durch die unabhängigen Ansprüche gelöst. Bevorzugte Ausführungsformen sind Gegenstand der abhängigen Ansprüche.

### Solarpaneel gemäß einem Aspekt

Ein Aspekt der vorliegenden Erfindung betrifft ein Solarpaneel umfassend zumindest ein im wesentlichen plattenförmiges Solarmodul und zumindest eine auf einer Anschlussseite des Solarmoduls angeordnete Anschlußdose. Das Solarmodul umfasst zumindest zwei elektrische Leiter und eine von der Anschlussseite abgewandte Bestrahlungsseite. Die Anschlussdose umfasst einen ersten und zweiten Anschlußpol und zumindest zwei elektrische Leiterkontakte, wobei ein erster der zumindest zwei elektrischen Leiterkontakte mit einem ersten elektrischen Leiter des Solarmoduls kontaktiert ist und ein zweiter der zumindest zwei elektrischen Leiterkontakte mit einem zweiten elektrischen Leiter des Solarmoduls kontaktiert ist. Erfindungsgemäß umfasst die Anschlussdose des Solarpaneels ein Stellglied, das den ersten Anschlußpol mit dem ersten Leiterkontakt und den zweiten Anschlußpol mit dem zweiten Leiterkontakt elektrisch verbindet und dazu ausgebildet ist, einen vorgegebenen elektrischen Eingangsstrom I_{E}, welcher über den ersten und zweiten elektrischen Leiterkontakt dem Stellglied zugeführt wird, in einen vorbestimmbaren Ausgangsstrom I_{A}, welcher über den ersten und zweiten Anschlußpol fließt, oder eine vorgegebene elektrische Eingangsspannung U_{E}, welche zwischen dem ersten und zweiten elektrischen Leiterkontakt anliegt, in eine vorbestimmbare Ausgangsspannung U_{A}, welche zwischen dem ersten und zweiten Anschlußpol anliegt, zu konvertieren.

Der erste und zweite Anschlußpol sind ausgelegt, ein an die Anschlußdose angeschlossenes Solarmodul mit einem elektrischen Verbraucher zu verbinden. Da das Solarmodul eine Gleichspannung erzeugt, kann der erste Anschlußpol mit "-" bzw. als Minuspol und der zweite Anschlußpol mit "+" bzw. als Pluspol bezeichnet werden. Im Betrieb fließt zwischen dem ersten und dem zweiten Anschlußpol innerhalb der Anschlußdose der nach außen wirksame Ausgangsstrom I_{A} entlang der technischen Stromrichtung vom Minuspol zum Pluspol, wobei zwischen den zwei Anschlußpolen die Ausgangsspannung U_{A} anliegt.

Das Solarmodul, welches mit der Anschlußdose kontaktiert ist, weist zumindest zwei elektrische Leiter auf. Die zumindest zwei elektrischen
Leiterkontakte sind mit dem Stellglied elektrisch verbunden, so daß in Abhängigkeit von der auf das Solarmodul wirkenden Bestrahlungsintensität eine elektrische Eingangsspannung U_{E} an dem Stellglied anliegt. Gemäß der Strom-Spannungs-Kennlinie des Solarmoduls fließt ein elektrischer Eingangsstrom I_{E}, so daß dem Stellglied die Eingangsleistung P_{E} zur Verfügung gestellt wird. Da die Strom-Spannungs-Kennlinie des Solarmoduls nichtlinear ist, ergibt sich in Abhängigkeit von den Betriebsbedingungen, wie beispielsweise der Temperatur des Solarmoduls im Betrieb, für eine bestimmtes Spannungs-Stromstärken-Wertepaar eine maximale Eingangsleistung P_{E,max}. Dieses Spannungs-Stromstärken-Wertepaar mit maximaler Eingangsleistung ist der optimale Arbeitspunkt des Solarmoduls.

Bevorzugt ist das Stellglied ausgelegt, den Innenwiderstand des Stellglieds zwischen den mit dem Solarmodul verbundenen elektrischen Leiterkontakten zu regeln, so daß die Eingangsspannung U_{E} in Abhängigkeit einer bekannten Strom-Spannungs-Kennlinie des Solarmoduls einen elektrischer Eingangsstrom I_{E} bewirkt, so daß die Differenz zwischen der tatsächlichen Eingangsleistung P_{E} und der maximalen Eingangsleistung P_{E,max} minimal bzw. Null ist. Mit anderen Worten ist das Stellglied ausgelegt, das Solarmodul stets im optimalen Arbeitspunkt zu betreiben.

In Abhängigkeit von den Erfordernissen des/der an dem Solarpaneel angeschlossenen Verbraucher(s), stellt das Stellglied an den zwei Anschlußpolen einen vorbestimmbaren Ausgangsstrom I_{A} bzw. eine vorbestimmbare Ausgangsspannung U_{A} bereit. Dazu konvertiert das Stellglied den Eingangsstrom I_{E} bzw. die Eingangsspannung U_{E} zu dem gewünschten Ausgangsstrom I_{A} bzw. der gewünschten Ausgangsspannung U_{A}.

Vorteilhafterweise kann ein an das Solarpaneel angeschlossener Verbraucher mit einer gleichbleibenden Stromstärke bzw. Spannung versorgt werden. Weiter vorteilhafterweise können Solarpaneele in einer Solaranlage zusammen in Reihe geschaltet werden, wobei die Solarmodule der Solarpaneele unterschiedliche Strom-Spannungs-Kennlinien aufweisen können, ohne daß aufgrund von unterschiedlichen erzeugten Ausgangsstromstärken bzw. Ausgangsspannungen, elektrische Verlustleistungen in den leistungsarmen Solarpaneelen auftreten.

Weiter vorteilhaft ist es, daß durch die Verwendung des Stellglieds alle Solarmodule einer Solaranlage im optimalen Arbeitspunkt betrieben werden können. Insbesondere können zum einen abgeschattete Solarmodule, die im Gegensatz zu nicht abgeschatteten Solarmodulen eine sehr viel geringere Leistung erzeugen können, weiter in einem optimalen Arbeitspunkt, nämlich dem unter der Bedingung der Abschattung, betrieben werden und zum anderen kann auf die Verwendung einer Bypass-Schaltung für das gesamte Solarmodul mittels einer Bypass-Diode verzichtet werden.

Herkömmlicherweise sind die Bypass-Dioden eines Solarmoduls ausgelegt eine niederohmige Verbindung bzw. einen Kurzschluß zwischen den Anschlußpolen herzustellen, wenn zwischen diesen Anschlußpolen eine vorbestimmbare Spannung anliegt. Falls die Spannung zwischen den zwei Anschlußpolen einen vorbestimmbaren Schwellwert überschreitet, so verliert die Bypass-Diode ihre Sperrwirkung und stellt einen Kurzschluß zwischen den zwei Anschlußpolen her. Eine Überschreitung des Schwellwertes wird insbesondere durch eine Abschattung eines Solarmoduls einer Solaranlage bewirkt, während die übrigen Solarmodule einer Solaranlage nicht abgeschattet sind und einen entsprechend hohen Ausgangsstrom erzeugen. Da das abgeschattete Solarmodul als Widerstand wirkt, träte ohne einen durch die Bypass-Diode erzeugten Kurzschluß im Solarmodul eine unerwünschte Verlustleistung auf, die zur Erwärmung und möglicherweise zur Beschädigung des abgeschatteten Solarmoduls führt. Eine über dem abgeschatteten Solarmodul abfallenden Spannung, die einen vorbestimmten Schwellwert überschreitet, führt deshalb bei Verwendung einer Bypass-Diode zur wirkungsmäßigen Abschaltung des Solarmoduls, um dieses zu schützen und die Verlustleistung, insbesondere auch der Gesamtheit aller in Reihe geschalteten Solarpaneele, zu verringern.

Das Stellglied ermöglicht es vorteilhafterweise ebenfalls ein abgeschattetes Solarmodul zu schützen, da der durch das Solarmodul fließenden Eingangsstrom I_{E} von dem durch den über die Anschlußpole fließenden Ausgangsstrom I_{A} entkoppelt ist, so daß keine erhöhte Verlustleistung auftritt. Weiter vorteilhafterweise kann das Solarmodul weiter im optimalen Arbeitspunkt betrieben werden, wobei die dabei erzeugte elektrische Leistung über das Stellglied auf den vorbestimmten Ausgangsstrom I_{A} bzw. die vorbestimmte Ausgangsspannung U_{A} konvertiert wird, so daß diese zusätzliche nutzbare elektrische Leistung vorteilhafterweise zu einer erhöhten elektrischen Leistung der gesamten Solaranlage führt. Eine Bypass-Diode ist mit Verwendung des Stellgliedes nicht notwendig.

Der Begriff "Kontakt" bzw. "kontaktieren" im Sinne der vorliegenden Erfindung beinhaltet insbesondere elektrischen und/oder mechanischen Kontakt.

### Bevorzugte Ausführungsformen der Anschlußdose

Vorzugsweise ist das Stellglied ein Gleichstromsteller. Gleichstromsteller werden auch als DC-DC-Konverter bzw. DC-DC-Wandler bezeichnet. Der Gleichstromsteller wandelt einen konstanten Eingangsstrom I_{E} oder eine konstante Eingangsspannung U_{E} um, insbesondere durch periodische Schalten und mittels Zwischenpufferung von elektrischer Energie in einem Induktor oder in einer Kapazität, so daß ein anderer Ausgangsstrom I_{A} bzw. eine anderer Ausgangsspannung U_{A} am Ausgang des Gleichstromstellers entsteht. Vorteilhafterweise können der Eingangsstrom I_{E} und die Eingangsspannung U_{E} derart vorbestimmt sein, daß das Solarmodul gemäß der solarmoduleigenen Strom-Spannungs-Kennlinie im optimalen Arbeitspunkt arbeitet, während der Gleichstromsteller ausgangsseitig einen vorbestimmbaren bzw. gewünschten Ausgangsstrom I_{A} bzw. eine gewünschte Ausgangsspannung U_{A} bereitstellt.

Vorzugsweise umfaßt das Stellglied zumindest einen Metalloxid-Feldeffekttransistor (MOSFET). Weiter vorzugsweise kann das Stellglied auch ein IGBT (Insulated Gate Bipolar Transistor) oder einen Thyristor umfassen.

Vorzugsweise umfaßt die Anschlußdose eine Regelvorrichtung, die mit dem Stellglied elektrisch verbunden ist.

Vorzugsweise umfaßt die Anschlußdose eine Stromquelle (29), insbesondere einen Akkumulator. Die Stromquelle kann regenerativ, d.h. wiederaufladbar sein, wobei das Aufladen mittels des Solarmoduls erfolgen kann, wenn dieses beleuchtet wird. Die Stromquelle kann vorzugsweise auch über den über die Anschlußpole fließenden Strom geladen werden. Weiter bevorzugt kann die Stromquelle über eine externe Ladevorrichtung geladen werden. Vorteilhafterweise kann die Regeleinrichtung auch betrieben werden, wenn das Solarpaneel nicht durch die Sonne beleuchtet wird.

Vorzugsweise weist die Regelvorrichtung eine Schnittstelle auf, so daß die Regelvorrichtung mit einer externen Steuereinrichtung verbindbar ist. Insbesondere kann die Regelvorrichtung auch einen Mikroprozessor aufweisen.

Vorzugsweise ist die Schnittstelle eine galvanische, eine opto-elektronische, eine kapazitive und/oder eine induktive Schnittstelle. Bevorzugt kann die Schnittstelle ein Steckverbinder, eine Radiofrequenz-Verbindung bzw. eine Verbindung mittels elektromagnetischer Wellen und/oder eine Glasfaserverbindung sein. Vorteilhafterweise ist eine Fernabfrage der in der Regeleinrichtung erfaßten bzw. gespeicherten Betriebsparameter über die Schnittstelle möglich. Weiter vorteilhafterweise kann ein unbefugter Eingriff in das Solarpaneel (z.B. Vandalismus oder Diebstahl) über die Schnittstelle an die externe Steuereinrichtung gemeldet werden. Ferner ist es möglich Betriebsparameter vorzugeben, wie beispielsweise die Vorgabe des gewünschten Ausgangsstromes I_{A}.

Vorzugsweise umfaßt die Anschlußdose eine Schaltvorrichtung, welche die elektrische Verbindung zwischen dem ersten und dem zweiten Anschlußpol in einem ersten Schaltzustand trennt und in einem zweiten Schaltzustand herstellt. Die Schaltvorrichtung kann bevorzugt einen Schalter und/oder ein Relais umfassen. Vorteilhafterweise kann das Solarpaneels von einem daran angeschlossenen Verbraucher, insbesondere automatisch und/oder durch die externe Steuervorrichtung, getrennt werden, beispielsweise in unsicheren Betriebszuständen, vor der Endmontage, und/oder während Wartungsarbeiten.

Vorzugsweise wird die Schaltvorrichtung von der Regelvorrichtung gesteuert. Bevorzugt erfolgt eine Verbindung des Solarpaneel mit einem angeschlossenen Verbraucher erst durch eine externe Freischaltung über die Schnittstelle mittels der

### Verwendung gemäß einem Aspekt

Ein weiterer Aspekt der vorliegenden Erfindung betrifft die Verwendung eines erfindungsgemäßen Solarpaneels in einer Anordnung zur Erzeugung von elektrischer Energie aus Licht mit zumindest einem Wechselrichter, welcher einen ersten und zweiten elektrischen Wechselrichteranschlußpol aufweist, wobei der erste Anschlußpol der Anschlußdose des Solarpaneels mit dem ersten Wechselrichteranschlußpol und der zweite Anschlußpol der Anschlußdose des Solarpaneels mit dem zweiten Wechselrichteranschlußpol unmittelbar oder mittelbar elektrisch verbunden ist.

Wechselrichter benötigen im allgemeinen einen konstanten vorbestimmten Eingangsstrom, der in diesem Fall gleich dem Ausgangsstrom I_{A} des zumindest einen Solarpaneels ist, um einen maximalen Wirkungsgrad zu erreichen. Vorteilhafterweise kann die von dem Solarpaneel erzeugte Stromstärke vorbestimmt werden, vorzugsweise auf die von dem Wechselrichter benötigte Stromstärke. Weiter vorteilhafterweise können verschiedene Solarpaneele mit verschiedenen

Weiter vorteilhafterweise können verschiedene Solarpaneele mit verschiedenen Solarmodulen (d.h. Solarmodule mit unterschiedlichen Strom-Spannungs-Kennlinien) in Reihe geschaltet werden, wobei die einzelnen Solarmodule im optimalen Arbeitspunkt betrieben werden können, um die maximale elektrische Leistung zu erzeugen, wobei im wesentlichen alle Solarpaneele den vorbestimmten Ausgangsstrom I_{A} erzeugen und dem Wechselrichter an den Wechselrichteranschlußpolen bereitstellen. Vorteilhafterweise ist die gesamte von der Anordnung, auch als Solaranlage bezeichnet, erzeugte elektrische Leistung maximal.

### Figurenbeschreibung

Nachfolgend werden bevorzugte Ausführungsformen der vorliegenden Erfindung anhand der beigefügten Zeichnungen beispielhaft erläutert. Es zeigen:
- Figur 1:: einen schematischen Aufbau einer Ausführungsform eines Solarpaneels;
- Figur 2:: ein elektrisches Schaltbild einer gemischten Anordnung mit einem erfindungsgemäßem Solarpaneel und zwei herkömmliche Solarpaneelen;
- Figur 3:: eine perspektivische Ansicht einer Solaranlage.

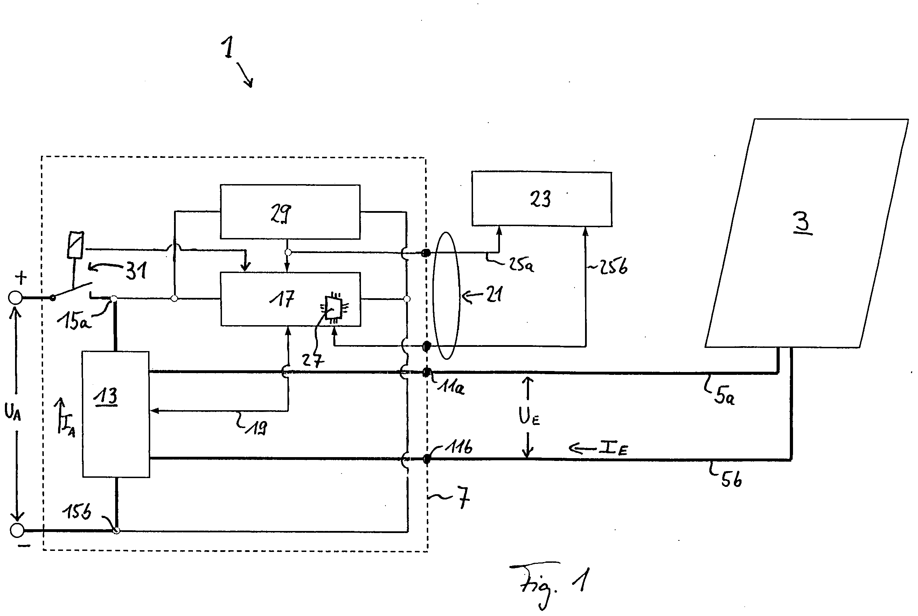

**Figur 1** zeigt einen schematischen Aufbau einer Ausführungsform eines Solarpaneels 1 mit einem plattenförmigen Solarmodul 3, wobei auf einer Bestrahlungsseite des Solarmoduls 3 zumindest eine spannungserzeugende Solarzelle angeordnet ist, deren elektrische Leiter 5a, 5b aus dem Solarmodul 3 herausgeführt und mit einer Anschlußdose 7 kontaktiert sind. Die Anschlußdose 7 ist an bzw. auf einer der Bestrahlungsseite abgewandten Anschlußseite des Solarmoduls 3 an bzw. auf diesem angeordnet.

Die Anschlußdose 7 umfaßt in dieser Ausführungsform zwei elektrische Leiterkontakte 11a, 11b , wobei ein erster 11a der elektrischen Leiterkontakte mit dem ersten elektrischen Leiter 5a des Solarmoduls 3 kontaktiert ist und ein zweiter 11b der elektrischen Leiterkontakte mit dem zweiten elektrischen Leiter 5b des Solarmoduls 3 kontaktiert ist.

Die Anschlußdose 7 umfaßt weiter einen Gleichstromsteller 13 als bevorzugte Ausführungsform eines Stellglieds 13, wobei der erste und zweite Leiterkontakt 11a, 11b mit dem Stellglied 13 kontaktiert sind. Das Stellglied 13 ist weiter mit einem ersten 15a und zweiten 15b Anschlußpol der Anschlußdose 7 kontaktiert. Das Stellglied stellt einen elektrischen Kontakt zwischen dem ersten Anschlußpol 15a und dem ersten Leiterkontakt 11a sowie dem zweiten Anschlußpol 15b und dem zweiten Leiterkontakt 11b her.

Ein von dem Solarmodul 3 erzeugter elektrischer Eingangsstrom I_{E}, welcher über die elektrischen Leitungen 5a, 5b sowie die Leiterkontakte 11a, 11b zu dem Stellglied 13 und wieder zurück zum Solarmodul 3 fließt, wird durch das Stellglied 13 in einen vorbestimmbaren Ausgangsstrom I_{A} konvertiert und an den Anschlußpolen 15a, 15b bereit gestellt. Alternativ kann eine von dem Solarmodul 3 erzeugte elektrische Eingangsspannung U_{E}, welche zwischen den elektrischen Leitungen 5a, 5b sowie den Leiterkontakten 11a, 11b anliegt und dem Stellglied 13 zugeführt wird, durch das Stellglied 13 in eine vorbestimmbare Ausgangsspannung U_{A} konvertiert werden und zwischen den Anschlußpolen 15a, 15b anliegen. Die Anschlußpole 15a, 15b können als Anschlußkabel oder als Verbinder ausgebildet sein.

Die in der Figur 1 gezeigte Anschlußdose 7 umfaßt eine Regelvorrichtung 17, welche mit dem Stellglied 13 über die Steuerleitung 19 verbunden ist. Die Regeleinrichtung speichert vorzugsweise den gewünschten Ausgangsstrom I_{A} bzw. die gewünschte Ausgangsspannung U_{A}. Gemäß den in der Regeleinrichtung 17 gespeicherten vorbestimmten Werten konvertiert das Stellglied 13 den durch das Solarmodul erzeugten Strom bzw. die erzeugte Spannung in den gewünschten Ausgangsstrom I_{A} bzw. die gewünschte Ausgangsspannung U_{A}. Bevorzugt ist in der Regeleinrichtung 17 die Strom-Spannungs-Kennlinie des Solarmoduls 3 gespeichert, so daß die Regeleinrichtung 17 den Innenwiderstand des Stellgliedes 13 zwischen den Leiterkontakten 11a, 11b derart vorgeben kann, daß das Stellglied 13 durch Einstellen seines Innenwiderstandes das Solarmodul 3 gemäß der gespeicherten Strom-Spannungs-Kennlinie im optimalen Arbeitspunkt halten kann, um vorteilhafterweise die durch das Solarmodul 3 abgegebene elektrische Leistung zu maximieren.

In dieser bevorzugten Ausführungsform umfaßt die Regelvorrichtung 17 eine Schnittstelle 21, so daß die Regelvorrichtung 17 mit einer externen Steuereinrichtung 23 verbindbar ist. Die Schnittstelle 21 kann mittels einer galvanischen bzw. elektrischen oder einer opto-elektronischen Verbindung ausgebildet sein, so daß die Regeleinrichtung 17 mittels der Steuerleitungen 25a, 25b, z.B. elektrische Kabel oder Glasfaserkabel, mit der externen Steuereinrichtung 23 verbunden ist. Die Schnittstelle 21 kann auch als kapazitive und/oder induktive Schnittstelle ausgebildet sein, die eine berührungsfreie Verbindung zwischen Regeleinrichtung 17 und externer Steuereinrichutng 23 herstellen kann. Mittels der Steuerleitungen 25a, 25b bzw. der berürhungsfreien Verbindung, insbesondere über elektromagnetische Wellen, ist eine Fernabfrage zu den in der Regeleinrichtung 17 erfaßten bzw. gespeicherten Betriebsparameter möglich. Ferner ist es möglich Betriebsparameter vorzugeben, wie beispielsweise die Vorgabe des gewünschten Ausgangsstromes I_{A}.

Um die Kommunikation über die Schnittstelle 21 zu ermöglichen kann die Regeleinrichtung 17 einen vorzugsweise einen Mikroprozessor 27 umfassen. Bevorzugt umfaßt die Regelvorrichtung 17 zur Erfassung der aktuellen Betriebsparameter eine Strommeßeinrichtung und/oder eine Spannungsmeßeinrichtung, um die aktuellen Werte der Eingangsspannung U_{E}, der Eingangsstromstärke I_{E}, der Ausgangsspannung U_{A} und/oder der Ausgangsstromstärke I_{A} zu erfassen und zur Regelung des Stellgliedes zu verwenden bzw. diese aktuellen Werte der externen Steuereinrichtung 23 zur Verfügung zu stellen.

Um die Regeleinrichtung 17 mit elektrischer Energie zu versorgen, umfaßt die Anschlußdose 7 vorzugsweise eine Stromquelle 29. Die Stromquelle kann beispielsweise ein Akkumulator sein, welcher durch das Solarmodul geladen wird, wenn dieses beleuchtet wird. Alternativ oder zusätzlich kann der Akkumulator mittels des über die Anschlußpole 15a, 15b fließenden Stroms geladen werden oder über eine an die Schnittstelle 21 angeschlossene Ladevorrichtung. Vorteilhafterweise kann die Regeleinrichtung 17 auch betrieben werden, wenn das Solarmodul 3 nicht beleuchtet wird bzw. wenn kein Strom über die Anschlußpole 15a, 15b fließt.

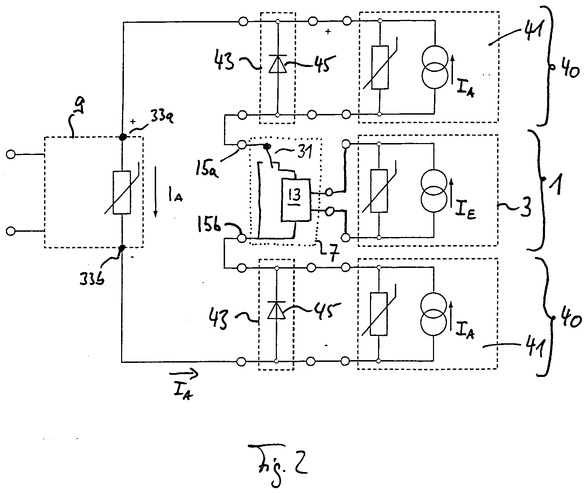

Die Anschlußdose 7 umfaßt in der bevorzugten Ausführungsform eine Schaltvorrichtung 31, welche die elektrische Verbindung zwischen dem ersten 15a und dem zweiten Anschlußpol 15b schaltet. In einem ersten Schaltzustand sind die beiden Anschlußpole 15a, 15b voneinander elektrisch getrennt, so daß das Solarpaneel 1 ausgeschaltet und der Ausgangsstrom unterbrochen ist. Dies führt vorteilhafterweise zu einer Außerbetriebnahme des Solarpaneels 1 und der weiteren angeschlossenen Vorrichtungen, beispielsweise in einer betrieblichen Notsituation, z.B. einem Brand, oder bei der Montage des Solarpaneels 1, um einen Stromfluß beim Kontaktieren des Solarpaneels 1 zu vermeiden. Alternativ zu der in Figur 1 gezeigten Schaltvorrichtung 31, kann die Schaltvorrichtung auch ein Umschalten ausführen, so daß in einem ersten Schaltzustand ein Kurzschluß zwischen den Anschlußpolen 15a, 15b hergestellt wird, so daß lediglich das Solarpaneel 1 außer Betrieb gesetzt ist, jedoch ein Strom über die Anschlußpole 15a, 15b fließen kann (wie in Figur 2 gezeigt). Die Schaltvorrichtung 31 wird bevorzugt von der Regelvorrichtung 17 gesteuert, so daß das Schalten mittels der externen Steuereinrichtung 23 erfolgen kann. Alternativ oder zusätzlich kann die Schaltvorrichtung 31 auch manuell betätigt werden, insbesondere unmittelbar durch einen Schalter an der Anschlußdose 7.

**Figur 2** zeigt das elektrische Schaltbild einer gemischten Anordnung mit einem erfindungsgemäßen Solarpaneel 1 und zwei zueinander identische herkömmliche Solarpaneele 40. Die herkömmlichen Solarpaneele 40 weisen jeweils ein Solarmodul 41 und eine Anschlußdose 43 auf, die jeweils eine Bypass-Diode 45 umfaßt, welche im Falle einer Abschattung des entsprechenden Solarmoduls 41 kurz schließt.

In Reihe mit den herkömmlichen Solarpaneelen 40 ist ein erfindungsgemäßes Solarpaneel 1 geschaltet, welches ein Stellglied 13 und eine Schaltvorrichtung 31 aufweist, welche die zwei Anschlußpole 15a, 15b miteinander elektrisch verbindet. Als Verbraucher in Reihe mit den Solarpaneelen 1, 40 ist ein Wechselrichter 9 mit einem ersten 33a und einem zweiten 33b Wechselrichteranschlußpol geschaltet.

Die zwei identischen Solarmodule 41 sollen beispielsweise von dem Solarmodul 3 verschieden sein, insbesondere eine verschiedene Strom-Spannungs-Kennlinie aufweisen. Der Ausgangsstrom I_{A} ist somit durch die Solarmodule 41 festgelegt. Vorteilhafterweise kann das erfindungsgemäße Solarpaneel derart betrieben werden, daß das Solarmodul 3 im optimalen Arbeitspunkt arbeitet, da der von dem Solarpaneel 3 erzeugte Eingangsstrom I_{E} durch das Stellglied 13 an den Ausgangsstrom I_{A} angepaßt wird. Es kommt vorteilhafterweise nicht zu elektrischen Verlustleistungen an einem der in Reihe geschalteten Solarpaneele 1, 40, obwohl diese unterschiedliche Strom-Spannungs-Kennlinien aufweisen. Dadurch kann der Wechselrichter 9 vorteilhafterweise zuverlässig mit Strom versorgt werden.

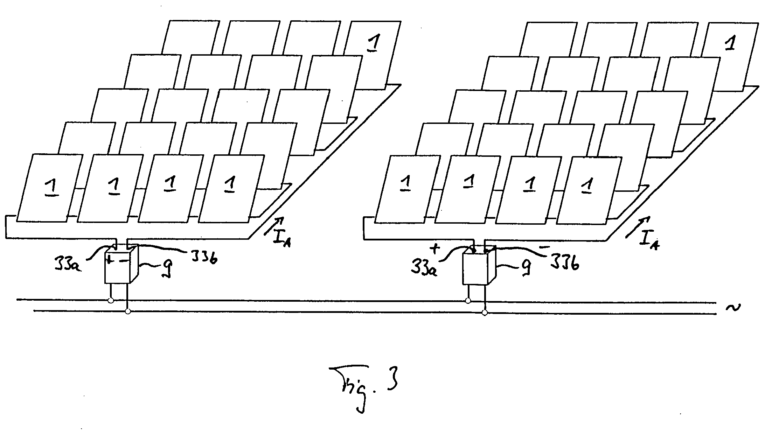

**Figur 3** zeigt eine perspektivische Ansicht einer Anordnung 35 zur Erzeugung von elektrischer Energie aus Licht bzw. einer Solaranlage 35. Die Solaranlage 35 umfaßt zwei Wechselrichter 9, welche jeweils einen ersten 33a und zweiten 33b Wechselrichteranschlußpol aufweisen, über welche der Ausgangsstrom I_{A} der in Reihe geschalteten Solarpaneele 1 fließt. Die Wechselrichter 9 benötigen zwecksmäßigerweise eine konstanten vorbestimmten Ausgangsstrom I_{A}, um einen maximalen Wirkungsgrad zu erreichen. Mittels der erfindungsgemäßen Anschlußdosen (in Fig. 3 nicht gezeigt) kann die von den einzelnen Solarpaneelen 1 erzeugte Stromstärke vorbestimmt werden, vorzugsweise auf die von den Wechselrichtern 9 benötigte Stromstärke. Vorteilhafterweise können die Solarmodule der erfindungsgemäßen Solarpaneele 1 gemäß ihrer, nicht zwingend identischen, Strom-Spannungs-Kennlinien im optimalen Arbeitspunkt betrieben werden und die maximale elektrische Leistung erzeugen und zeitgleich können die Solarpaneele 1 einen vorbestimmten Ausgangsstrom I_{A} über die Wechselrichteranschlußpole 33a, 33b erzeugen, so daß der Wechselrichter 9 einen maximalen Wirkungsgrad erreicht. Vorteilhafterweise ist die gesamte von der Solaranlage 35 erzeugte elektrische Leistung maximal.

Die vorliegende Erfindung ist nicht auch die obigen, beispielhaft beschriebenen Ausführungsformen beschränkt. Vielmehr können einzelne Elemente und/oder Merkmale eines jeden beschriebenen Aspekts und/oder einer jeden beschriebenen Ausführungsform mit einzelnen Elementen und/oder Merkmalen der weiteren Aspekte und/oder weiteren Ausführungsformen in beliebiger Weise miteinander kombiniert werden und somit weitere Aspekte und/oder Ausführungsformen gebildet werden.

### Bezugszeichenliste

- 1: Solarpaneel
- 3: Solarmodul
- 5a, 5b: elektrischer Leiter des Solarmoduls 3
- 7: Anschlußdose
- 9: Wechselrichter
- 11a, 11b: Leiterkontakt
- 13: Stellglied
- 15a, 15b: Anschlußpol
- 17: Regelvorrichtung
- 19: Steuerleitung
- 21: Schnittstelle
- 23: externe Steuereinrichtung
- 25a, 25b: Steuerleitung
- 27: Mikroprozessor
- 29: Stromquelle
- 31: Schaltvorrichtung
- 33a, 33b: Wechselrichteranschlußpol
- 35: Solaranlage
- 40: herkömmliches Solarpaneel
- 41: Solarmodul
- 43: herkömmliche Anschlußdose
- 45: Bypass-Diode
- U_{A}: Ausgangsspannung
- I_{A}: Ausgangsstrom
- U_{E}: Eingangsspannung
- I_{E}: Eingangsstrom

## Patentansprüche

1. Solarpaneel (1) umfassend
- zumindest ein im wesentlichen plattenförmiges Solarmodul (3), welches zumindest zwei elektrische Leiter (5a, 5b) und eine von der Anschlussseite abgewandte Bestrahlungsseite umfasst, und
- zumindest eine auf einer Anschlussseite des Solarmoduls (3) angeordnete Anschlussdose (7), welche einen ersten (15a) und zweiten Anschlusspol (15b) und zumindest zwei elektrische Leiterkontakte (11a, 11b) umfasst, von denen ein erster (11a) mit dem ersten elektrischen Leiter (5a) kontaktiert ist und ein zweiter (11b) mit dem zweiten elektrischen Leiter (5b) kontaktiert ist,
**dadurch gekennzeichnet, dass** die Anschlussdose (7) des Solarpaneels (1) ein Stellglied (13) umfasst, das den ersten Anschlusspol (15a) mit dem ersten Leiterkontakt (11a) und den zweiten Anschlusspol (15b) mit dem zweiten Leiterkontakt (11b) elektrisch verbindet und dazu ausgebildet ist, einen vorgegebenen elektrischen Eingangsstrom I_{E}, welcher über den ersten (11a) und zweiten (11b) elektrischen Leiterkontakt dem Stellglied (13) zugeführt wird, in einen vorbestimmbaren Ausgangsstrom I_{A}, welcher über den ersten (15a) und zweiten Anschlusspol (15b) fliesst, oder eine vorgegebene elektrische Eingangsspannung UE, welche zwischen dem ersten (11a) und zweiten (11b) elektrischen Leiterkontakt anliegt, in eine vorbestimmbare Ausgangsspannung UA, welche zwischen dem ersten (15a) und zweiten Anschlusspol (15b) anliegt, zu konvertieren.

2. Solarpaneel (1) nach Anspruch 1, wobei das Stellglied (13) ein Gleichstromsteller (13) ist.

3. Solarpaneel (1) nach Anspruch 1 oder 2, wobei das Stellglied (13) zumindest einen Metalloxid-Feldeffekttransistor umfasst.

4. Solarpaneel (1) nach einem der vorigen Ansprüche, wobei die Anschlussdose (7) eine Regelvorrichtung (17) umfasst, die mit dem Stellglied elektrisch verbunden ist.

5. Solarpaneel (1) nach einem der vorigen Ansprüche, wobei die Anschlussdose (7) eine Stromquelle (29) umfasst.

6. Solarpaneel (1) nach einem der vorigen Ansprüche, wobei die Regelvorrichtung (17) eine Schnittstelle (21) aufweist, so dass die Regelvorrichtung (17) mit einer externen Steuereinrichtung (23) verbindbar ist.

7. Solarpaneel (1) nach Anspruch 6, wobei die Schnittstelle (21) eine galvanische, eine opto-elektronische, eine kapazitive und/oder eine induktive Schnittstelle (21) ist.

8. Solarpaneel (1) nach einem der vorigen Ansprüche, wobei die Anschlussdose (7) eine Schaltvorrichtung (31) umfasst, welche dazu ausgebildet ist, die elektrische Verbindung zwischen dem ersten (15a) und dem zweiten Anschlusspol (15b) in einem ersten Schaltzustand zu trennen und in einem zweiten Schaltzustand herzustellen.

9. Solarpaneel (1) nach Anspruch 8, wobei die Regelvorrichtung (17) dazu ausgebildet ist, die Schaltvorrichtung (31) zu steuern.

10. Verwendung eines Solarpaneels (1) nach einem der vorherigen Ansprüche in einer Anordnung (35) zur Erzeugung von elektrischer Energie aus Licht mit zumindest einem Wechselrichter (9), welcher einen ersten (33a) und zweiten elektrischen Wechselrichteranschlusspol (33b) aufweist, wobei der erste Anschlusspol (15a) der Anschlussdose (7) des Solarpaneels (1) mit dem ersten Wechselrichteranschlusspol (33a) und der zweite Anschlusspol (15b) der Anschlussdose (7) des Solarpaneels (1) mit dem zweiten Wechselrichteranschlusspol (33b) unmittelbar oder mittelbar elektrisch verbunden ist.

## Claims

1. A solar panel (1), comprising:
- at least one substantially panel-shaped solar module (3) that comprises at least two electrical conductors (5a, 5b) and an irradiation side facing away from the connection side, and
- at least one connection socket (7) that is arranged on a connection side of the solar module (3) and comprises a first (15a) and second connecting pole (15b), and at least two electrical conductor contacts (11a, 11b) of which a first (11a) is contacted by the first electrical conductor (5a) and a second (11b) is contacted by the second electrical conductor (5b),
**characterized in that** the connecting socket (7) of the solar panel (1) comprises an actuator (13) that electrically connects the first connecting pole (15a) to the first conductor contact (11a) and the second connecting pole (15b) to the second conductor contact (11b) and is designed to convert a given electrical input current IE, that is fed via the first (11a) and second (11b) electrical conductor contact to the actuator (13), into an output current IA that can be predetermined and flows via the first (15a) and second connecting pole (15b), or converts a given electrical input voltage UE that is between the first (11a) and second (11b) electrical conductor contact into an output voltage UA that can be predetermined and is between the first (15a) and second connecting pole (15b).

2. The solar panel (1) according to claim 1, wherein the actuator (13) is a chopper (13).

3. The solar panel (1) according to claim 1 or 2, wherein the actuator (13) comprises at least one metal oxide field effect transistor.

4. The solar panel (1) according to one of the preceding claims, wherein the connecting socket (7) comprises a control device (17) that is electrically connected to the actuator.

5. The solar panel (1) according to one of the preceding claims, wherein the connecting socket (7) comprises a power source (29).

6. The solar panel (1) according to one of the preceding claims, wherein the control device (17) has an interface (21) so that the control device (17) can be connected to an external control apparatus (23).

7. The solar panel (1) according to claim 6, wherein the interface (21) is a galvanic, optoelectronic, capacitive, and/or inductive interface (21).

8. The solar panel (1) according to one of the preceding claims, wherein the connecting socket (7) comprises a switching device (31) that is designed to disconnect the electrical connection between the first (15a) and the second connecting pole (15b) in a first switching state, and to establish the electrical connection in a second switching state.

9. The solar panel (1) according to claim 8, wherein the control device (17) is designed to control the switching device (31).

10. The use of a solar panel (1) according to one of the preceding claims in an arrangement (35) for generating electrical energy from light with at least one inverter (9) that has a first (33a) and a second electrical converter connecting pole (33b), wherein the first connecting pole (15a) of the connecting socket (7) of the solar panel (1) is electrically connected to the first inverter connecting pole (33a), and the second connecting pole (15b) of the connecting socket (7) of the solar panel (1) is electrically connected to the second inverter connecting pole (33b) directly or indirectly.

## Revendications

1. Panneau solaire (1) comprenant
- au moins un module solaire essentiellement en forme de plaque (3) qui comprend au moins deux conducteurs électriques (5a, 5b) et un côté d'irradiation détourné du côté de raccordement, et
- au moins une boîte de jonction (7) disposée sur un côté de raccordement du module solaire (3) qui comprend un premier (15a) et second pôle de raccordement (15b) et au moins deux contacts de conducteur électriques (11a, 11b) parmi lesquels un premier (11a) est contacté avec le premier conducteur électrique (5a) et un second (11b) est contacté avec le second conducteur électrique (5b),
**caractérisé en ce que** la boîte de jonction (7) du panneau solaire (1) comprend un composant de réglage (13) qui relie électriquement le premier pôle de raccordement (15a) au premier contact de conducteur (11a) et le second pôle de raccordement (5b) au second contact de conducteur (11b) et est réalisé pour convertir un courant d'entrée électrique prédéfini I_{E} qui est amené au composant de réglage (13) par le biais du premier (11a) et second (11b) contact de conducteur électrique en un courant de sortie pouvant être prédéterminé IA qui s'écoule par le biais du premier (15a) et second pôle de raccordement (15b), ou une tension d'entrée électrique prédéfinie U_{E} qui s'applique entre le premier (11a) et second (11b) contact de conducteur électrique en une tension de sortie pouvant être prédéterminée UA qui s'applique entre le premier (15a) et second pôle de raccordement (15b).

2. Panneau solaire (1) selon la revendication 1, dans lequel le composant de réglage (13) est un convertisseur direct de courant continu (13).

3. Panneau solaire (1) selon la revendication 1 ou 2, dans lequel le composant de réglage (13) comprend au moins un transistor à effet de champ à oxyde métallique.

4. Panneau solaire (1) selon une des revendications précédentes, dans lequel la boîte de jonction (7) comprend un dispositif de régulation (17) qui est relié électriquement au composant de réglage.

5. Panneau solaire (1) selon une des revendications précédentes, dans lequel la boîte de jonction (7) comprend une source de courant (29).

6. Panneau solaire (1) selon une des revendications précédentes, dans lequel le dispositif de régulation (17) présente une interface (21) de sorte que le dispositif de régulation (17) peut être relié à un dispositif de commande externe (23).

7. Panneau solaire (1) selon la revendication 6, dans lequel l'interface (21) est une interface galvanique, opto-électronique, capacitive et/ou inductive (21).

8. Panneau solaire (1) selon une des revendications précédentes, dans lequel la boîte de jonction (7) comprend un dispositif de commutation (31) qui est réalisé pour séparer la liaison électrique entre le premier (15a) et le second pôle de raccordement (15b) dans un premier état de commutation et l'établir dans un second état de commutation.

9. Panneau solaire (1) selon la revendication 8, dans lequel le dispositif de régulation (17) est réalisé pour commander le dispositif de commutation (31).

10. Utilisation d'un panneau solaire (1) selon une des revendications précédentes dans un agencement (35) pour la génération d'énergie électrique à partir de lumière avec au moins un onduleur (9) qui présente un premier (33a) et second pôle de raccordement d'onduleur électrique (33b), dans laquelle le premier pôle de raccordement (15a) de la boîte de jonction (7) du panneau solaire (1) est relié électriquement directement ou indirectement au premier pôle de raccordement d'onduleur (33a) et le second pôle de raccordement (15b) de la boîte de jonction (7) du panneau solaire (1) est relié électriquement directement ou indirectement au second pôle de raccordement d'onduleur (33b).
